# EUROPEAN PATENT SPECIFICATION

(11) **EP 3 243 854 B1**
(45) Date of publication and mention of the grant of the patent: **18.11.2020**
(21) Application number: 16169512.7
(22) Date of filing: 13.05.2016
(51) Int. Cl.: C08G 59/08, H05K 3/28, C08G 59/17, C08G 59/14, C08L 63/10, H05K 1/03

(54) **LOW DK/DF SOLDER RESISTANT COMPOSITION USED FOR PRINTED CIRCUIT BOARD**
LÖTBESTÄNDIGE ZUSAMMENSETZUNG MIT GERINGEM DK/DF FÜR EINE LEITERPLATTE
COMPOSITION À FAIBLE DK/DF, RÉSISTANTE À LA SOUDURE, UTILISÉE POUR CARTE DE CIRCUIT IMPRIMÉ

(43) Date of publication of application: 15.11.2017
(73) Proprietor: Nan-Ya Plastics Corporation, Taipei (TW)
(72) Inventor: LEE, Cheng-Chung, Taipei (TW); HWANG, Yeong-Tong, Taipei (TW); HSU, Shih-Hung, Taipei (TW); HWANG, Shao-En, Taipei (TW)
(74) Representative: Viering, Jentschura & Partner mbB Patent- und Rechtsanwälte

(56) References cited:
- WO-A1-03/059975
- JP-A- H07 157 703
- JP-A- 2003 048 932
- TW-A- 201 113 323
- US-A1- 2007 129 502

## Description

### [Technical Fields]

The present invention relates to a novel low Dk/Df solder resistant composition with outstanding developing performance and photo-hardening force; and the printed circuit board manufactured has excellent adhesion, chemical resistance, electric characteristics, plating resistance, solder heat resistance, electric erosion resistance, as well as dielectric constant of less than 3.20 (1GHz) and dissipation factor Df of less than 0.015 (1GHz); and the low Dk/Df solder resistant composition is applicable for the high-performance and high-frequency printed circuit board.

### [Prior Art]

Liquid solder resistant composition or dry membrane having excellent developability and dimension precision has been widely applied to the method of manufacturing photoresisting patterns of all kinds of printed circuit boards in recent years in order to keep up with the high wiring density of the printed circuit board, especially the hardened solder resistant coating with excellent physical property can be prepared finally from the solder resistant composition formed by the ultraviolet curable resin (photopolymerizable prepolymer (oligomer)) prepared from multifunctional phenolic aldehyde epoxy acrylic resin or multifunctional o-cresol formaldehyde epoxy acrylate to which polybasic anhydride-anhydride is added and the epoxy resin composition after heating and hardening when the ultraviolet ray is applied to hardening.

US 20070129502 A1 discloses a curable resin composition including a component (A) which is a polyphenylene ether oligomer having a number-average molecular weight of 700 to 4,000 and having a vinyl group at both end and a component (B) which is a solvent-soluble polyfunctional vinylaromatic copolymer which has structural units derived from monomers including a divinylaromatic compound (a) and an ethylvinylaromatic compound (b) and in which the content of repeating units derived from the divinylaromatic compound (a) is 20 mol % or higher, the ratio of the amount (wt. %) of the component (A) to that (wt. %) of the component (B) being (20 to 98):(2 to 80).

WO 2003059975 A1 discloses a photosensitive resin composition and purine preparative wiring board including (A) a resin curable with actinic radiation, (B) a photopolymerization initiator, (C) a reactive diluent, and (D) an epoxy compound, wherein the resin (A) is composed of (a) a prepolymer produced by esterifying a novolak-type epoxy compound with an unsaturated carboxylic acid and reacting the resulting epoxy-esterification product with a saturated or unsaturated polybasic acid anhydride, (b) a prepolymer produced by esterifying a bisphenol-type epoxy compound with an unsaturated carboxylic acid and reacting the resulting epoxy-esterification product with a saturated or unsaturated polybasic acid anhydride, and (c) a prepolymer produced by reacting an unsaturated monobasic acid copolymer resin with an alicyclic epoxy-containing unsaturated compound.

The solder resistant composition formed by the photopolymerizable prepolymer (oligomer) prepared from phenolic aldehyde epoxy acrylic resin or multifunctional o-cresol formaldehyde epoxy acrylate and the common epoxy resin, such as the crystalline epoxy resin or any di-functional group epoxy resin has the dielectric constant Dk of about 3.6 (1GHz) and dissipation factor Df of about 0.025 (1GHz) and cannot acquire the transmission characteristics of electronic signal; however, the upstream raw materials of the printed circuit board are required to have low dielectric constant Dk and dissipation factor Df along high-frequency and high-speed development of the electronic product and increasing transmission speed, and the solder resistant composition also becomes the key and important raw material for protecting circuit. Therefore, to develop the solder resistant composition having low dielectric constant/dissipation factor and meeting the physical property of the printed circuit board is crucial problem in the future.

### [Summary of The Invention]

The developing direction in the future shall require the upstream raw materials of the printed circuit board to have lower dielectric constant Dk and dissipation factor Df consecutively because the electronic product requires the faster transmission speed of high-frequency signal. As the important materials of resisting soldering and protecting the circuit of the printed circuit board, to develop the solder resistant composition of low dielectric constant Dk and dissipation factor Df shall be the crucial subject.

The present invention is to provide the novel low Dk-Df solder resistant composition with outstanding developing performance and photo-hardening force, and the printed circuit board manufactured has excellent adhesion, chemical resistance, electric characteristics, plating resistance, solder heat resistance, electric erosion resistance, as well as dielectric constant of less than 3.20 (1GHz) and dissipation factor Df of less than 0.015 (1GHz); and the low Dk/Df solder resistant composition is applicable for the high-performance and high-frequency printed circuit board.

The novel low Dk/Df solder resistant composition contains following components
(A) a photopolymerizable prepolymer oligomer as represented by formula 1 in an amount of 20-70 weight%, prepared by reacting (a1) dicyclo pentadiene-phenol novolac multifunctional epoxy, polyphenyl ether modified epoxy resin (a2) or phenol-benzaldehyde novolac multifunction epoxy (a3) or any combination of three (a1), (a2), (a3) with acrylic acid (b), then reacting with a saturated or unsaturated anhydride acid (c);
(B) a photopolymerizable vinyl monomer 0-20 weight% as thinner;
(C) an epoxy compound 5-30 weight% containing dicyclo pentadiene-phenol novolac multifunctional epoxy resin or polyphenyl ether modified epoxy resin or phenol-benzaldehyde novolac multifunction epoxy or any combination of the forgoing three kinds of resins (C1); tetra methyl biphenol epoxy resin (C2); and optionally active ester resin (C3);
(D) a photopolymerization initiator in an amount of 2-10 weight%;
(E) an inorganic filler in an amount of 10-50 weight%;
(F) a catalyst in an amount of 0-2.0 weight%;
(G) an organic solvent in an amount of 10-40 weight%; 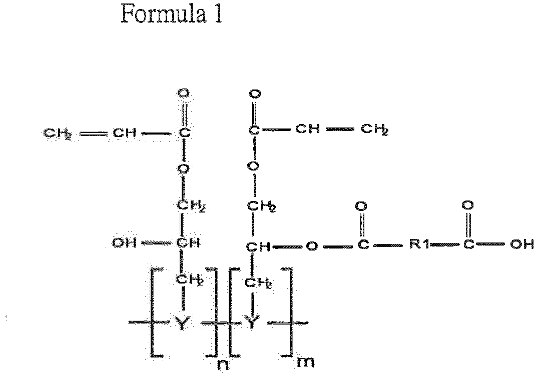
n,m >o,integer
R1: 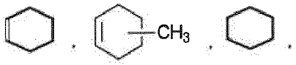 CH₂-CH₂ , CH**-**CH
Y: 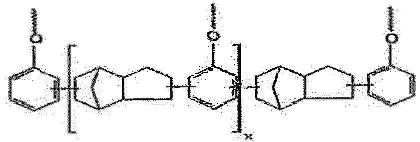 or 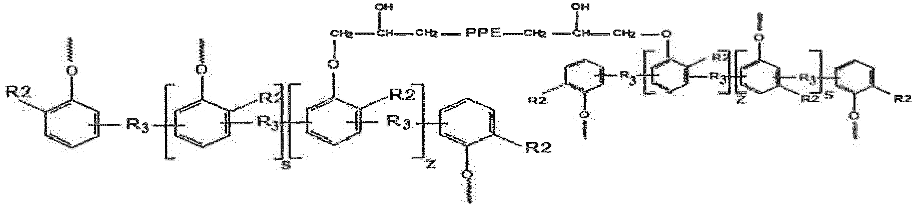 x,z,s>o ,Integer
R₃ : -CH₂- or 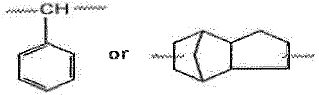 R2: H or CH₃
**or** 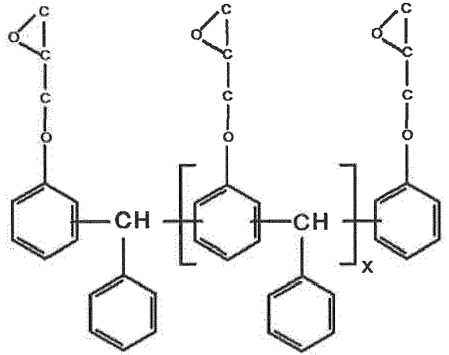 PPE: 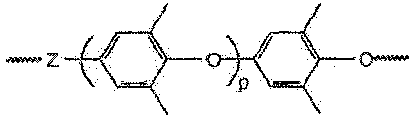 or 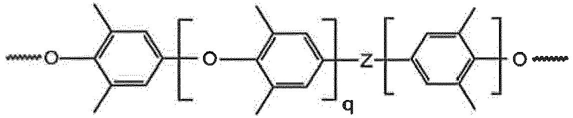 p,q>1 ,integer
Z: 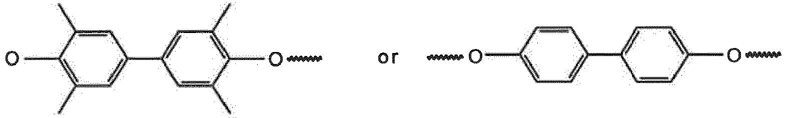 or

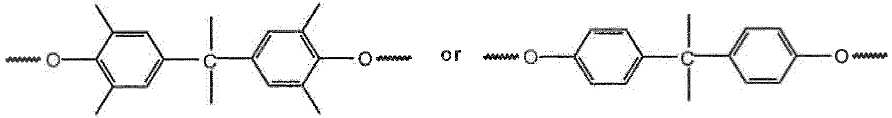

The novel low Dk/Df solder resistant composition of the invention is characterized in that the photopolymerizable prepolymer (oligomer, represented by Formula 1) with low dielectric constant and dissipation factor is put forward and by which the photopolymerizable prepolymer (oligomer) with low dielectric constant and dissipation factor can be synthesized and prepared by reacting the multifunctional epoxy resin having low polarity and high-symmetry chemical structure, such as dicyclo pentadiene-phenol novolac multifunctional epoxy resin or polyphenyl ether PPE modified epoxy resin or phenol-benzaldehyde novolac multifunctional epoxy resin with single carboxylic acid with one ethylene group and reacting with the saturated or unsaturated anhydride acid, and the main formula of the solder resistant composition can be formed by adding the heat curing agent of epoxy resin compound. The epoxy resin compound also has low polarity and high-symmetry chemical structure, for example, the effect of low Dk/Df can be implemented by means of dicyclo pentadiene-phenol novolac multifunctional epoxy resin or polyphenyl ether PPE modified epoxy resin or phenol-benzaldehyde novolac multifunctional epoxy resin and the crystalline tetramethyl diphenol epoxy resin; the dielectric constant and dissipation factor are lower if the active ester resin (aryl-esterized the phenolic hydroxyl group of the polyhydric phenol compound) is added; and the active ester resin is to play the role of preventing production of hydroxyl (OH group) polar group as a result of ring opening of the epoxy resin; the solder resist hardening coating refers to polymer coating bridged after hardening of the photopolymerizable prepolymer (oligomer) (acid value 20-100 mgKOH/g) and the epoxy resin by means of ultraviolet ray and heating for reaction, wherein the equivalence ratio of the photopolymerizable prepolymer (oligomer) to the epoxy resin is 1: (1.0-5.0) usually, and the epoxy resin shall provide excellent heat resistance, adhesion, chemical resistance; but the epoxy resin shall generate adverse factors to reduction of dielectric constant and dissipation factor as a result of polar group of hydroxyl (OH group) due to ring opening; the low-polarity ester may generated by the acyl in the active ester resin and the hydroxyl bond of the polar group after adding the active ester group resin, and therefore the problem that the dielectric constant and dissipation factor cannot be reduced easily as a result of hydroxyl generated after opening of the ring of the epoxy resin can be solved, and the low Dk/Df effect can be achieved relatively.

The content of the low Dk/Df solder resistant composition of the invention shall be detailed as follows: the component (A) photopolymerizable prepolymer (oligomer) is included and 20-70 weight% preferably, 30-60 weight% most preferably and synthesized and prepared by reacting (a) low-Dk multifunctional epoxy resin with (b) mono carboxlic acid containing at least one vinyl group, and reacting with (c) saturated or unsaturated anhydride acid, wherein the best effect can be acquired when the reaction condition is within following range: the low-Dk multifunctional epoxy resin shall prevail in terms of quantity for reaction between the (a) low-Dk multifunctional epoxy resin and (b) mono carboxlic acid containing at least one vinyl group, and epoxy group of each equivalent weight shall be 0.5-1.2 mole preferably, and 0.9-1.1 mole most preferably. During the reaction, the organic solvent shall be applied to dilution, such as petroleum-based aromatic solvent, propylene carbonate, butoxyethanol, butoxyethyl acetate, methylbenzene, dimethylbenzene, butyl carbitol acetate, cyclohexanone, propylene glycol monomethyl ether, dipropylene glycol diethyl ether, methyl carbitol acetate; and the catalyst is added, such as triphenylphosphine, triethylamine, methyltriethylammonium chloride, wherein the triphenylphosphine shall be the best choice. The catalyst shall be 0.1-10 weight% of the total amount of the mixture for reaction preferably. The thermal polymerization inhibitor shall be added, such as p-dihydroxybenzene and hydroquinone dimethyl ether in order to prevent polymerization during reaction. The polymerization inhibitor shall be 0.01-1 weight% of the mixture for reaction after feeding preferably, and the reaction temperature shall be at 80-120°C preferably, and the reaction shall be lasted for 6-24h. And the step of reacting with (c) saturated or unsaturated anhydride shall be lasted, and the hydroxyl generated during reaction between the carboxyl and the epoxy group shall prevail in terms of quantity of anhydride used, the 0.1-1.0 mole of anhydride shall be applied to the hydroxyl of equivalent weight, and 0.3-0.8 mole most preferably; the reaction shall be implemented at 80-120°C preferably, and the reaction shall be lasted for 4-16h. Moreover, the acid value (mg KOH/g) of the photopolymerizable prepolymer (oligomer) (A) acquired in this way shall be 20-100 preferably, and 40-80 most preferably.
(a) low-Dk multifunctional epoxy resin is selected from dicyclo pentadiene-phenol novolac multifunctional epoxy resin (produced by Nan Ya Plastics Corporation, with trademark NPPN-272H, equivalent of epoxy EEW of 272g/eq and softening point at 78-85°C) or polyphenyl ether modified epoxy resin (produced by Nan Ya Plastics Corporation, with trademark NPPN-433PT60, equivalent of epoxy EEW of 340g/eq, average molecular weight of Mn1300 and solid content of 60%) or phenol-benzaldehyde novolac multifunctional epoxy resin (produced by Nan Ya Plastics Corporation, with trademark NPPN-433, equivalent of epoxy EEW of 230g/eq and average molecular weight of Mn1150) or arbitrary combinations of the above-mentioned three epoxy resins.
(b) mono carboxlic acid containing at least one vinyl group is selected from acrylic acid, methylacrylic acid, crotonic acid, cinnamic acid, and acrylic acid shall be preferable in the embodiment.
(c) saturated or unsaturated anhydride acid is selected from succinic anhydride, hexahydrophthalic anhydride, cis-4-methyl-1,2,3,6-tetrahydrophthalic anhydride, 2,3,6-tetrahydro-3-phthalic anhydride, maleic anhydride, and 2,3,6-tetrahydro-3-phthalic anhydride shall be preferable in the embodiment.

The dosage of the component (B) photopolymerizable vinyl monomer of the solder resistant composition with low dielectric constant and dissipation factor in the invention is 0-20 weight% preferably, and 5-15 weight% most preferably; further, the component (B) is selected from acrylate including tripolycyanamide, hydroxyalkyl acrylate, such as mono acrylic acid or diacrylic acid compound of 2-hydroxyethyl acrylate, 2-hydroxybutyl acrylate, dihydric alcohol (such as glycol, polyglycol, propanediol), alkyl amine acrylic acid compound, such as acrylic acid-nitrogen, nitrogen- dimethylaminoethyl, polyhydrol (such as glycol, trimethylpropane, pentaerythritol, dipentaerythritol) and ethylene oxide, multifunctional acrylate of propylene oxide (which can be adducted itself), and acrylate of allyl glycidyl ether (glycidyl diepoxy ether, trimethylolpropane diepoxypropyl ether, melaminecyanurate triepoxy isoamyl propionate), and acrylate or pentaerythritol of tripolycyanamide, multifunctional acrylate of dipentaerythritol most preferably.

The dosage of the component (C) epoxy resin compound of the solder resistant composition with low dielectric constant and dissipation factor in the invention is 5-30 weight%, and preferably 10-25 weight% , and the epoxy resin compound is selected from (C1) dicyclo pentadiene-phenol novolac multifunctional epoxy resin (produced by Nan Ya Plastics Corporation, with trademark NPPN-272H, equivalent of epoxy EEW of 272g/eq and softening point at 78-85°C) or polyphenyl ether modified epoxy resin (produced by Nan Ya Plastics Corporation, with trademark NPPN-433PT60, equivalent of epoxy EEW of 340g/eq and average molecular weight of Mn1300) or phenol-benzaldehyde novolac multifunctional epoxy resin (produced by Nan Ya Plastics Corporation, with trademark NPPN-433, equivalent of epoxy EEW of 230g/eq and average molecular weight of Mn1150) or arbitrary combinations of the above-mentioned three epoxy resins, (C2) tetra methyl biphenol epoxy resin, and (C3) the active ester resin (aryl-esterized the phenolic hydroxyl group of the polyhydric phenol compound) of any esterified structure of phenolic resin.

The epoxy resin compound is applied to crosslinking with the (A) polymerizable oligomer as the heat hardening agent; while the acid equivalent of the above-mentioned polymerizable oligomer shall prevail in terms of dosage of the epoxy resin compound used, and 1.0-5.0 mole of epoxy group shall be applied to the carboxylic group equivalently, preferably 1.0-2.5 mole.

The total epoxy resin (C1)+(C2) shall prevail in terms of dosage of (C3) active ester resin, preferably 0-1.0 mole active ester resin shall be applied to the epoxy group equivalently; the minority of the hydroxyl (OH group) is reservable when the amount of the active ester resin is less than the equivalent weight of the epoxy resin in order to acquire better adhesion effect. Further, the equivalent weight of the active ester resin is 190-280g/eq.

The dosage of the component (D) photopolymerization initiator of the solder resistant composition with low dielectric constant and dissipation factor in the invention is 2-10 weight%, preferably 2-8 weight%, and the photopolymerization initiator is selected from any of known photoinitiators, such as benzoin methyl ether, benzoin, isopropyl ether, 2,2-dimethyl-2-phenylacetophenone, 1,1-dichloroacetophenone, 1-hydroxy cyclohexyl phenyl ketone, 2-methyl-1-[4-(methylthio) phenyl]-2-morpholinylacet-1-one, N,N-dimethyl amino acetophenone, 2,4-dimethyl 9-oxdibenzothian, 2,4-diethyl 9-oxdibenzothian, 2-chloro-9-oxdibenzothian, 2,4-diisopropyl 9-oxdibenzothian, benzophenone dimethyl acetal, diphenylketone, methyl diphenylketone, 4,4'-dichlorobenzophenone, 4,4'-diethylamino phenyl ketone, Michler's ketone, 4-phenylmethylacyldiphenyl phosphorus oxide, which can be used separately or after mixing. Moreover, the best combination shall be 2-methyl-1-[4-(methylthio) phenyl]-2- morpholinylacet-1-one (Irgacure 907) and 2,4-diisopropyl 9-oxdibenzothian (Kayacure ITX manufactured by the chemical company in Japan).

The dosage of the component (E) inorganic filler of the solder resistant composition with low dielectric constant and dissipation factor in the invention is 10-50 weight%, preferably 15-35 weight%. The inorganic filler used by the composition of the invention is the one applied widely, such as mixture of talcum powder, magnesium carbonate, calcium carbonate, alumina, powder of silicon dioxide.

The dosage of the component (F) accelerant of the solder resistant composition with low dielectric constant and dissipation factor in the invention is 0-2.0 weight% and preferably 0.1-1.0 weight% . Moreover, the accelerant, as the hardening accelerant, can be selected from imidazoles, quaternary ammonium compounds, quaternary phosphates, and usually dimethyl imidazole, diphenylimidazole, bis(hydroxymethyl) diphenylimidazole.

The dosage of the component (G) organic solvent of the solder resistant composition with low dielectric constant and dissipation factor in the invention is 10-40 weight% and preferably 10-30 weight% . Moreover, the organic solvent is selected from propylene carbonate, butoxyethanol, butoxyethyl acetate, methylbenzene, dimethylbenzene, butyl carbitol acetate, cyclohexanone, propylene glycol monomethyl ether, dipropylene glycol diethyl ether, methyl carbitol acetate; and the propylene carbonate and the butoxyethyl acetate shall be preferable in the embodiment.

The technical solution of the invention has at least following beneficial effects:

The solder resistant composition can be prepared by steps of hardening by using ultraviolet ray and drying and hardening by means of heat after reacting dicyclo pentadiene-phenol novolac epoxy resin or polyphenyl ether modified multifunctional epoxy resin or phenol-benzaldehyde novolac multifunctional epoxy resin with mono carboxlic acid containing a vinyl group, synthesizing the low Dk/Df photopolymerizable prepolymer (oligomer) after reacting with the saturated or unsaturated polyatomic acid; substituting into the formula of the composition and adding the low Dk/Df epoxy resin compound (such as dicyclo pentadiene-phenol novolac epoxy resin or polyphenyl ether modified multifunctional epoxy resin or phenol-benzaldehyde novolac multifunctional epoxy resin and the crystalline tetramethyl diphenol epoxy resin). The invention is featured with excellent electrical property, low Dk/Df, high analyticity and developability, excellent adhesion, chemical resistance, electric characteristics, plating resistance, heat resistance of soldering materials, galvanic corrosion resistance, and meets the characteristic requirements of high-frequency high-speed and high-order printed circuit board. Moreover, the Dk/Df can be further reduced if the active ester resin is added to the formula of the composition.

### [Detailed Description of the Preferred Embodiment]

The preferable specific embodiment shall be clarified further in order to understand the invention more clearly, and explanations shall be detailed according to following embodiments.

### Synthesis example 1: Photopolymerizable prepolymer (oligomer)-A1

Add 390g solvent KA to 1000g dicyclo pentadiene-phenol novolac multifunctional epoxy resin (produced by Nan Ya Plastics Corporation, with trademark NPPN-272H and equivalent of epoxy EEW of 272g/eq); add 4.5g triphenyl phosphine and 1.0g hydroquinone HQ after heating the mixture to 100°C, stir and dissolve the mixture and drop 265g acrylic acid AA to the above-mentioned solution to carry out reaction, wherein the reaction time during dropping shall be 90min; the temperature during dropping shall be at 95°C; implement ripening reaction for 12h by heating the mixture to 120°C after dropping; add 380g tetrahydrophthalic anhydride THPA and 390g solvent I-150 when the acid value of analysis is less than 1mgKOH/g and implement reaction 5h when the temperature is at 110°C; then add 55g solvent KA and 55g 1-150 to dilute until the solid content is 65% to obtain the photopolymerizable prepolymer (oligomer) A1 with acid value of analysis of 60mgKOH/g and weight average molecular weight Mw of 1839.

### Synthesis example 2: Photopolymerizable prepolymer (oligomer) -A2

Add 378g solvent KA to 1000g polyphenyl ether modified benzaldehyde novolac multifunctional epoxy resin (produced by Nan Ya Plastics Corporation, with trademark NPPN-433P and EEW of 316g/eq); add 4.0g triphenyl phosphine and 1.0g hydroquinone HQ after heating the mixture to 100°C, stir and dissolve the mixture and drop 227g acrylic acid AA to the above-mentioned solution to carry out reaction, wherein the time of dropping shall be 90min; the temperature during dropping shall be at 95°C; implement ripening reaction for 12h after dropping and reaction for 5h after adding 327g tetrahydrophthalic anhydride THPA and 378g solvent I-150 when the temperature is at 110°C; then add 41g solvent KA and 41g 1-150 to dilute until the solid content is 65% to obtain the photopolymerizable prepolymer (oligomer) A2 with acid value of analysis of 77mgKOH/g and weight average molecular weight Mw of 1872.

### Synthesis example 3: Photopolymerizable prepolymer (oligomer) -A3

Add 405g solvent KA to 1000g phenol-benzaldehyde novolac multifunctional epoxy resin (produced by Nan Ya Plastics Corporation, with trademark NPPN-433 and EEW of 230g/eq); add 5.4g triphenyl phosphine and 1.0g hydroquinone HQ after heating the mixture to 100°C, stir and dissolve the mixture and drop 312g acrylic acid AA to the above-mentioned solution to carry out reaction, wherein the reaction time of dropping shall be 90min; the temperature during dropping shall be at 95°C; implement ripening reaction for 12h by heating the mixture to 120°C after dropping; carry out reaction for 5h after adding 450g tetrahydrophthalic anhydride THPA and 405g solvent 1-150 when the temperature is at 110°C; then add 71g solvent KA and 71g 1-150 to dilute until the solid content is 65% to obtain the photopolymerizable prepolymer (oligomer) A3 with acid value of analysis of 59mgKOH/g and weight average molecular weight Mw of 2267.

### Comparison example: Photopolymerizable prepolymer (oligomer) -A4

Add 392g solvent KA to 1000g o-cresol phenolic multifunctional epoxy resin (produced by Nan Ya Plastics Corporation, with trademark NPPN-704 and EEW of 210g/eq); add 6.0g triphenyl phosphine and 1.2g hydroquinone HQ after heating the mixture to 100°C, stir and dissolve the mixture and drop 342g acrylic acid AA to the above-mentioned solution to carry out reaction, wherein the time of dropping shall be 90min; the temperature during dropping shall be at 95°C; implement ripening reaction for 12h after dropping and reaction for 4h after adding 384g tetrahydrophthalic anhydride THPA and 392g solvent I-150 when the temperature is at 110°C; then add 128g solvent KA and 128g 1-150 to dilute until the solid content is 62.5% to obtain the photopolymerizable prepolymer (oligomer) A4 with acid value of analysis of 51 mgKOH/g and weight average molecular weight Mw of 6000.

### Examples 1-4

The low Dk/Df photopolymerizable prepolymer (oligomer) of the invention can be substituted into the formula of the solder resistant composition with components detailed in Table 1, and the photoresist ink composition can be acquired after grinding comprehensively by using SAMBON roller grinding machine. The printed circuit board of 20-30 thick can be acquired after coating the photoresist ink composition acquired by the method onto the copper printed circuit board having patterns by using the printing method in presence of screen. The membrane can be adhered to the coating by using the negative coating having photoresist patterns closely after drying for 30min by using the hot air drier at 80°C, and irradiated by ultraviolet light with dosage of 25mW/square centimeter by using the ultraviolet exposure device (of HMW-680GW type produced by ORC Company). Then the part not exposed can be dissolved and eliminated by developing for 60s in presence of spraying pressure of 2.0kg/square centimetre of 1% aqueous solution of sodium carbonate. Of course, the aqueous solutions of weak base of other types can also be used. Finally, the membrane hardened completely can be acquired after baking 0.5-1h at 100-200°C in order to increase the heat resistant performance.

### Comparison example 1

The comparison example involves that substitution of the common photopolymerizable prepolymer (oligomer) into the formula of the solder resistant composition, and the formula is detailed in the Table 1.

**Table 1: Constitution form of formulas of embodiments and comparison example**

| Component Project | Embodiment 1 | Embodiment 2 | Embodiment 3 | Embodiment 4 | Comparison example 1 |
|---|---|---|---|---|---|
| Photopolymerizable prepolymer (oligomer) (synthesis case 1-A1) | 44.8 | 44.8 | - | - | - |
| Photopolymerizable prepolymer (oligomer) (synthesis case 2-A2) | - | - | 44.8 | - | - |
| Photopolymerizable prepolymer (oligomer) (synthesis case 3-A3) | - | - | - | 44.8 | - |
| Photopolymerizable prepolymer (oligomer) (synthesis case-A4) | - | - | - | - | 44.8 |
| DPHA (dipentaerythritolpentaacrylate), acrylic monomer | 5.0 | 5.0 | 5.0 | 5.0 | 5.0 |
| dicyclo pentadiene-phenol novolac multifunctional epoxy resin (produced by Nan Ya Plastics Corporation, NPPN-272H) | 6.2 | 6.2 | - | - | - |
| PPE polyphenyl ether modified benzaldehyde novolac multifunctional epoxy resin (produced by Nan Ya Plastics Corporation, NPPN-433P) | - | - | 6.2 | - | - |
| Phenol-benzaldehyde novolac multifunction epoxy resin (produced by Nan Ya Plastics Corporation, NPPN-433) | - | - | - | 6.2 | - |
| Tetramethyl diphenol epoxy resin | 7.2 | 7.2 | 7.2 | 7.2 | 7.2 |
| Active ester resin | - | 7.5 | 7.5 | 7.5 | - |
| Photoinitiator | 5.6 | 5.6 | 5.6 | 5.6 | 5.6 |
| Filler | 24.3 | 18.6 | 18.6 | 18.6 | 32.3 |
| Accelerant | 0.2 | 0.2 | 0.2 | 0.2 | 0.2 |
| Solvent | 4.9 | 4.9 | 4.9 | 4.9 | 4.9 |
| Total | 100 | 100 | 100 | 100 | 100 |
| Developability (developing time: 90-120s) | ⊚ | ⊚ | ⊚ | ⊚ | ⊚ |
| Pencil hardness (H) | 5 | 5 | 5 | 5 | 7 |
| Adhesion | ⊚100/100 | ⊚100/100 | ⊚100/100 | ⊚100/100 | ⊚100/100 |
| Heat resistance to solder spray of taphole (270°C) | 3 times, pass | 3 times, pass | 3 times, pass | 3 times, pass | 3 times, pass |
| Soldering resistance of plug-in (260°C) | 3 times, pass | 3 times, pass | 3 times, pass | 3 times, pass | 3 times, pass |
| Dielectric constant Dk(1GHz) | 3.05 | 3.00 | 2.90 | 3.05 | 3.6 |
| Dissipation factor Df(1GHz) | 0.011 | 0.010 | 0.010 | 0.011 | 0.025 |

### Test of weight average molecular weight (Mw)

Dissolve the sample in the THF to prepare the solution with concentration of 0.5-2.0%; implement injection and analysis by using gel chromatograph, and set up correction curve chart of weight average molecular weight Mw/Mn by using the polystyrene standard.

### Developability

Brush and grind (linear speed: 2M/min; acid leach: 3% sulfuric acid; and drying: 90°C) the test board clearly and coat the ink on the circuit board by using the screen of 36T; bake the circuit board 40min in the drier at 75°C; take out the circuit board from the drier and cool it to room temperature naturally.

### Developing condition:

Concentration of developing solution: 1.0±0.2% Na₂CO₃ aqueous solution.
Spray pressure: 2.5 ±0.5Kg/cm2
Developing temperature: at 30-33°C
⊚: Complete developing
○: The trace part cannot be developed.
Δ: One part cannot be developed completely.
×: Cannot develop completely.

### Adhesion

The hardening mould shall have the part of lattice according to the test method specified by JIS D 0202. Moreover, the peeling condition can be evaluated with eyes after peeling test by using Sailuofan adhesive tape.
⊚: 100/100, that is, no peeling occurs to 100 parts.
○: 100/100, the minority of the part is peeled.
Δ: 50/100-90/100, that is, parts 50-90 in 100 are kept without peeling.
×: 0/100-50/100, that is, parts 0-50 in 100 are kept without peeling.

### Pencil hardness

Grind the tip (into right angle) of the 2B-9H pencil produced by Mitsubishi after manufacturing the test slide by using the method of adhesion and scratch the test slide with angle of 45 degrees until the coating is scratched.

### Heat resistance to solder spray of taphole

Brush and grind (linear speed: 2M/min; acid leach: 3% sulfuric acid; and drying: 90°C) the test board clearly and coat the ink on the test board by using the screen of 36T, wherein the wet coating shall be 36-42µm; each hole of the taphole part shall be full of ink and pre-baked 40min at 75°C; implement hardening with UV exposure energy of 500mJ/cm2 and hardening by means of segmented baking 30min at 85°C, 30min at 120°C and 60min at 15°C; coat the soldering flux (known) on the circuit board hardened, spray tin for 10s each time at 270°C until peel occurs (next test can be implemented when the board is cooled each test); and stop the test if no peeling occurs after three times of tests.

### Wave soldering resistance of plug-in

Brush and grind (linear speed: 2M/min; acid leach: 3% sulfuric acid; and drying: 90°C) the test board clearly and coat the ink on the test board by using the screen of 36T, wherein the wet coating shall be 36-42µm; hardening the circuit board by using the hardening method mentioned in heat resistance to solder spray of taphole; test the circuit board after hardening by using the wave welder under the conditions that the pre-heating section is at 250°C, the temperature of tin is at 260°C, the linear speed is at 1.3M/min, the soldering flux is KESTER 984, and the acid value of the soldering flux is 17-25mgKOH/g until peeling occurs (next test can be implemented when the board is cooled each test); and stop the test if no peeling occurs after three times of tests.

### Test of dielectric constant:

The test method shall include: harden the coating with thickness of 100um by using the 5cm×5cm square ink, clamp the test plate into the dielectric constant tester and acquire the average value after measuring the data of three points.

### Test of dissipation factor:

The test method shall include: harden the coating with thickness of 100um by using the 5cm×5cm square ink, clamp the test plate into the dielectric constant tester and acquire the average value after measuring the data of three points.

The embodiments 1-4 and the comparison example in the above-mentioned form show that the photopolymerizable prepolymer (oligomer) can be by reacting the dicyclo pentadiene-phenol novolac multifunctional epoxy resin with the acrylic acid and reacting with the methyl tetradrophthalic anhydride in the embodiment 1; the photopolymerizable prepolymer (oligomer) can be by reacting the dicyclo pentadiene-phenol novolac multifunctional epoxy resin with the acrylic acid and reacting with the methyl tetradrophthalic anhydride, and the active ester resin is added to the photopolymerizable prepolymer (oligomer) in the embodiment 2; the photopolymerizable prepolymer (oligomer) can be by reacting the polyphenyl ether modified multifunctional epoxy resin with the acrylic acid and reacting with the methyl tetradrophthalic anhydride, and the active ester resin is added to the photopolymerizable prepolymer (oligomer) in the embodiment 3; the photopolymerizable prepolymer (oligomer) can be by reacting the phenol-benzaldehyde novolac multifunction epoxy resin with the acrylic acid and reacting with the methyl tetradrophthalic anhydride, and the active ester resin is added to the photopolymerizable prepolymer (oligomer) in the embodiment 4; the photopolymerizable prepolymer (oligomer) synthesized in the above-mentioned embodiments 1-4 are substituted into the solder resist ink produced according to the formula and compared with the comparison example, wherein the dielectric constant can be reduced between 3.2 from 3.6, and the dissipation factor can be reduced below 0.015 from 0.025; and the solder resist ink is applicable for printed circuit board for high-frequency high-speed signal transmission.

## Claims

1. A low Dk/Df solder resistant composition contains following components:
A. a photopolymerizable prepolymer oligomer as represented by formula 1 in an amount of 20-70 weight%, prepared by: reacting dicyclo pentadiene-phenol novolac multifunctional epoxy (a1), polyphenyl ether modified epoxy resin (a2), or phenol-benzaldehyde novolac multifunction epoxy (a3), or any combination of three (a1), (a2), (a3) with acrylic acid (b), then reacting with a saturated or unsaturated anhydride acid (c);
B. a photopolymerizable vinyl monomer in an amount of 0-20 weight% as thinner;
C. an epoxy compound in an amount of 5-30 weight% containing dicyclo pentadiene-phenol novolac multifunctional epoxy resin or polyphenyl ether modified epoxy resin or phenol-benzaldehyde novolac multifunction epoxy or any combination of the forgoing three kinds of resins (C1); tetra methyl biphenol epoxy resin (C2); and optionally active ester resin (C3);
D. a photopolymerization initiator in an amount of 2-10 weight%;
E. an inorganic filler in an amount of 10-50 weight%;
F. a catalyst in an amount of 0-2.0 weight%;
G. an organic solvent in an amount of 10-40 weight%; 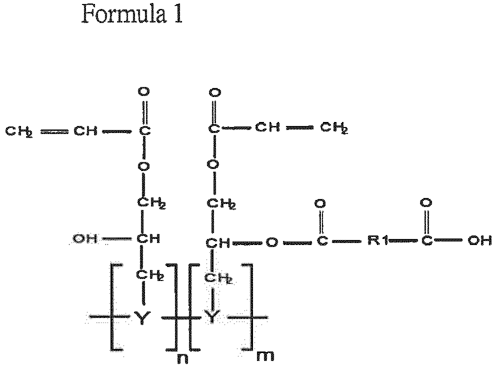 n,m >o,integer
R1: 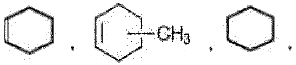 CH₂-CH₂ , CH-CH
Y: 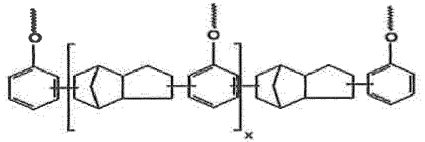 or 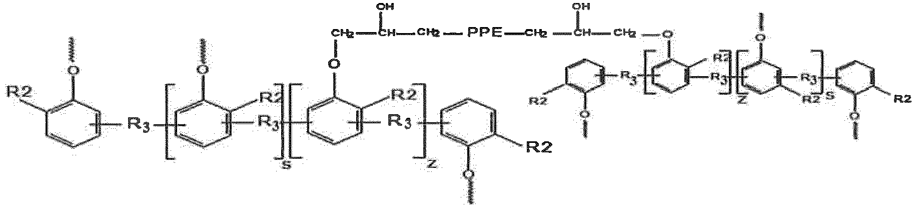 x,z,s>o ,Integer
R₃ : -CH₂- or 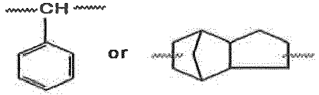 R2: H or CH₃
or 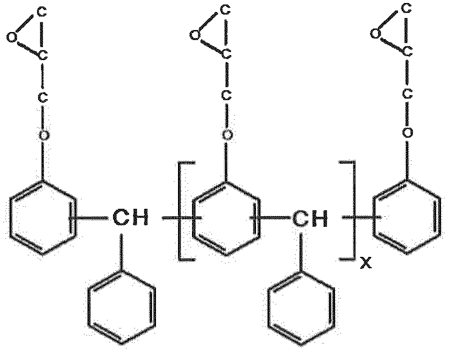 PPE: 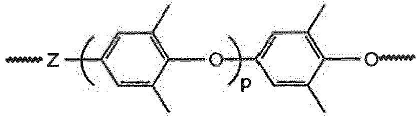 or 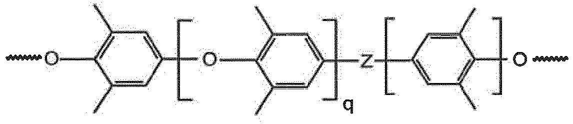 p,q>1 ,integer
Z: 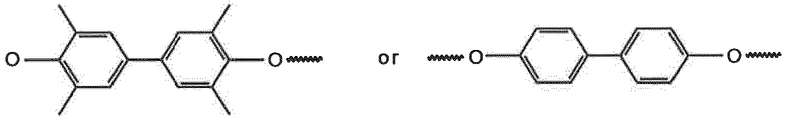 or

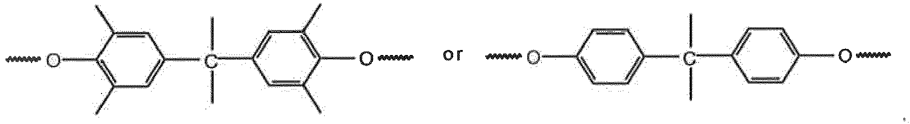

2. The low Dk/Df solder resistant composition as claimed in claim 1, wherein the component A photopolymerizable prepolymer oligomer is preferably in an amount of 20-70 weight% and most preferably in an amount of 30-60 weight% and synthesized and prepared by reacting low-Dk multifunctional epoxy resin (a) with acrylic acid (b), and reacting with a saturated or unsaturated acid anhydride (c) selected from succinic anhydride, maleic anhydride, hexahydrophthalic anhydride, methyl tetrahydrophthalic anhydride or cis-4-methyl-1,2,3,6-tetrahydrophthalic anhydride, wherein the reaction condition is preferably within following range in order to acquire the best effect: the low-Dk multifunctional epoxy resin prevails in terms of quantity for reaction between the low-Dk multifunctional epoxy resin (a) and acrylic acid (b), and epoxy group of each equivalent weight shall be 0.5-1.2 mole preferably, and 0.9-1.1 mole most preferably; during the reaction, the organic solvent shall be applied to dilution, such as petroleum-based aromatic solvent, propylene carbonate, butoxyethanol, butoxyethyl acetate, methylbenzene, dimethylbenzene, butyl carbitol acetate, cyclohexanone, propylene glycol monomethyl ether, dipropylene glycol diethyl ether, methyl carbitol acetate; and the catalyst is added, such as triphenylphosphine, triethylamine, methyltriethylammonium chloride, wherein the triphenylphosphine shall be the best choice; the catalyst shall be in an amount of 0.1-10 weight% of the total amount of the mixture for reaction preferably; the thermal polymerization inhibitor shall be added, such as p-dihydroxybenzene and hydroquinone dimethyl ether in order to prevent polymerization during reaction; the polymerization inhibitor shall be in an amount of 0.01-1 weight% of the mixture for reaction after feeding preferably, and the reaction temperature shall be at 80-120°C preferably, and the reaction shall be lasted for 6-24h; and in the step of reacting with saturated or unsaturated anhydride (c), the hydroxyl generated during reaction between the carboxyl and the epoxy group prevails in terms of quantity of anhydride used, the 0.1-1.0 mole of anhydride shall be applied to the hydroxyl of equivalent weight, and 0.3-0.7 mole most preferably; the reaction shall be implemented at 80-120°C preferably, and the reaction shall be lasted for 4-16h.

3. The composition as claimed in claim 1, wherein the dosage of the component (B) photopolymerizable vinyl monomer is in an amount of 0-20 weight%, and most preferably in an amount of 5-15 weight%, and the component (B) is selected from acrylate including tripolycyanamide, hydroxyalkyl acrylate-such as mono acrylic acid compound of 2-hydroxyethyl acrylate and 2-hydroxybutyl acrylate-acrylate including dihydric alcohol-such as glycol, polyglycol, propanediol-alkyl amine acrylic acid compound, nitrogen-dimethylaminoethyl, acrylate including polyhydrol-such as glycol, trimethylpropane, pentaerythritol, dipentaerythritol-and acrylate including ethylene oxide, multifunctional acrylate of propylene oxide-which can be adducted itself-and acrylate of allyl glycidyl ether-glycidyl diepoxy ether, trimethylolpropane diepoxypropyl ether, and melaminecyanurate triepoxy isoamyl propionate-and most preferably acrylate of pentaerythritol or acrylate of tripolycyanamide, multifunctional acrylate of dipentaerythritol.

4. The composition as claimed in claim 1, wherein the component (C) epoxy resin compound is in an amount of 5-30 weight%, and most preferably in an amount of 10-25 weight%, and the epoxy resin component (C) contains a first part (C1) selected from dicyclo pentadiene-phenol novolac multifunctional epoxy resin having equivalent of epoxy EEW of 272g/eq and softening point at 78-85°C or polyphenyl ether modified epoxy resin having equivalent of epoxy EEW of 340g/eq and average molecular weight of Mn1300 or phenol-benzaldehyde novolac multifunctional epoxy resin having equivalent of epoxy EEW of 230g/eq and average molecular weight of Mn1150 or arbitrary combinations of the above-mentioned three epoxy resins; a second part which is a tetra methyl biphenol epoxy resin (C2) and a third part which is a polyhydric phenol compound which phenolic hydroxyl group is aryl-esterized as the active ester resin (C3) and is selected from any of esterified structures of phenolic resin, wherein the acid equivalent of the above-mentioned polymerizable oligomer shall prevail in terms of dosage of the epoxy resin compound used, and 1.0-5.0 mole of epoxy group shall be applied to the carboxylic group equivalently, preferably 1.0-2.5 mole; total epoxy resin (C1)+(C2) shall prevail in terms of dosage of active ester resin (C3), preferably 0-1.0 mole active ester resin shall be applied to the epoxy group equivalently.

5. The composition as claimed in claim 1, wherein the dosage of the component (D) photopolymerization initiator of the solder resistant composition with low dielectric constant and dissipation factor in the invention is in an amount of 2-10 weight% and preferably in an amount of 2-8 weight%, and the photopolymerization initiator is selected from any of known photoinitiators, such as benzoin methyl ether, benzoin, isopropyl ether, 2,2-dimethyl-2-phenylacetophenone, 1,1-dichloroacetophenone, 1-hydroxy cyclohexyl phenyl ketone, 2-methyl-1-[4-(methylthio) phenyl]-2-morpholinylacet-1-one, N,N-dimethyl amino acetophenone, 2,4-dimethyl 9-oxdibenzothian, 2,4-diethyl 9-oxdibenzothian, 2-chloro-9-oxdibenzothian, 2,4-diisopropyl 9-oxdibenzothian, benzophenone dimethyl acetal, diphenylketone, methyl diphenylketone, 4,4'-dichlorobenzophenone, 4,4'-diethylamino phenyl ketone, Michler's ketone, 4-phenylmethylacyldiphenyl phosphorus oxide, which can be used separately or after mixing, and is preferably a combination of 2-methyl-1-[4-(methylthio) phenyl]-2-morpholinylacet-1-one and 2,4-diisopropyl 9-oxdibenzothian,

6. The composition as claimed in claim 1, wherein the dosage of the component (E) inorganic filler is in an amount of 10-50 weight% and most preferably in an amount of 15-35 weight%, and the inorganic fillers, such as talcum powder, magnesium carbonate, calcium carbonate, alumina, powder of silicon dioxide are used after mixing.

7. The composition as claimed in claim 1, wherein the dosage of the component (F) accelerant is in an amount of 0-2.0 weight% and most preferably in an amount of 0.1-1.0 weight%, and the hardening acceleran can be selected from imidazoles, quaternary ammonium compounds, and quaternary phosphates, and commonly dimethyl imidazole, diphenylimidazole, bis(hydroxymethyl) diphenylimidazole.

8. The composition as claimed in claim 1, wherein the dosage of the component (G) organic solvent is preferably in an amount of 10-40 weight% and most preferably in an amount of 10-30 weight%, and the organic solvent is preferably selected from propylene carbonate, butoxyethanol, butoxyethyl acetate, methylbenzene, dimethylbenzene, butyl carbitol acetate, cyclohexanone, propylene glycol monomethyl ether, dipropylene glycol diethyl ether, methyl carbitol acetate, and the propylene carbonate and the butoxyethyl acetate are more preferable. 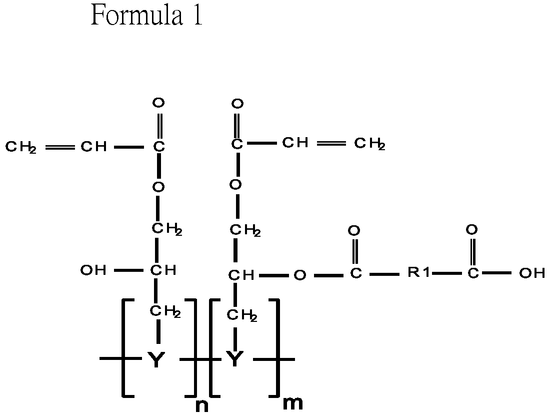 **n,m >o,integer**
**R1:** 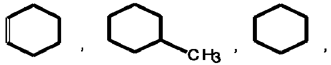 CH₂-CH₂ CH₂=CH₂

## Patentansprüche

1. Eine lötbeständige Zusammensetzung mit niedrigem Dk/Df enthält folgende Komponenten:
A. ein photopolymerisierbares Präpolymer-Oligomer, wie durch Formel 1 dargestellt, in einer Menge von 20-70 Gew.-%, hergestellt durch: Umsetzen von Dicyclopentadien-Phenol-Novolak-Multifunktionsepoxid (a1), Polyphenylether-modifiziertem Epoxidharz (a2) oder Phenol-Benzaldehyd-Novolak-Multifunktionsepoxid (a3) oder einer beliebigen Kombination der drei (a1), (a2), (a3) mit Acrylsäure (b), anschließend Umsetzen mit einem gesättigten oder ungesättigten Säureanhydrid (c);
B. ein photopolymerisierbares Vinylmonomer in einer Menge von 0-20 Gew.-% als Verdünner;
C. eine Epoxidverbindung in einer Menge von 5-30 Gew.-%, enthaltend Dicyclopentadien-Phenol-Novolak-Multifunktionsepoxidharz oder Polyphenylethermodifiziertes Epoxidharz oder Phenol-Benzaldehyd-Novolak-Multifunktionsepoxid oder eine beliebige Kombination der drei vorstehenden Harzarten (C1); Tetramethylbiphenol-Epoxidharz (C2); und wahlweise Aktivesterharz (C3);
D. einen Photopolymerisationsinitiator in einer Menge von 2-10 Gew.-%;
E. einen anorganischen Füllstoff in einer Menge von 10-50 Gew.-%;
F. einen Katalysator in einer Menge von 0-2,0 Gew.-%;
G. ein organisches Lösungsmittel in einer Menge von 10-40 Gew.-%; 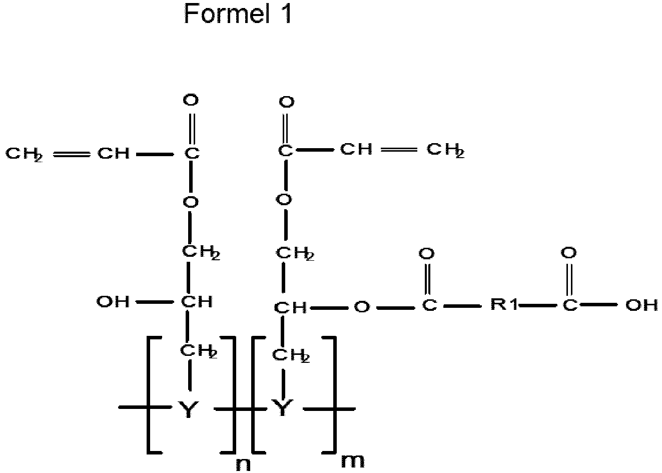 n, m > 0, ganze Zahl
R1 : 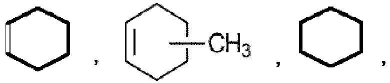 CH₂-CH₂ CH-CH
Y: 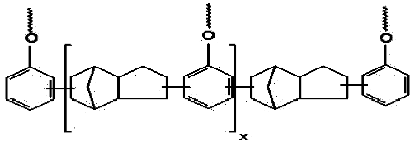 oder 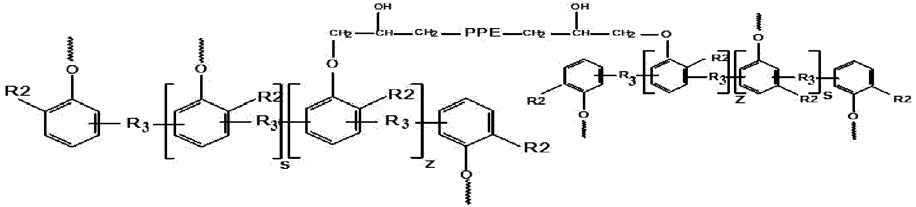 x,z,s>0, ganze Zahl
R₃ : -CH₂ - oder 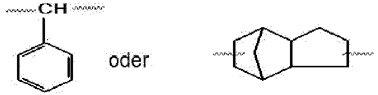 R2: H oder CH₃ oder 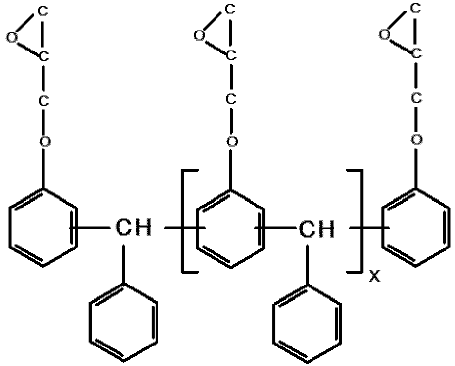 PPE: 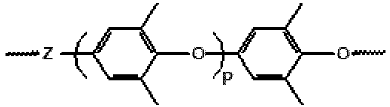 oder 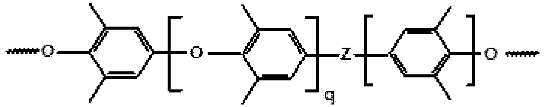 p,q>1, ganze Zahl
z: 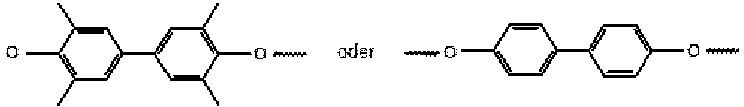 oder

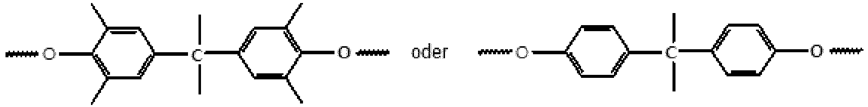

2. Die lötbeständige Zusammensetzung mit niedrigem Dk/Df gemäß Anspruch 1, wobei das Komponente A photopolymerisierbare Präpolymer-Oligomer vorzugsweise in einer Menge von 20-70 Gew.-% und am meisten bevorzugt in einer Menge von 30-60 Gew.-% vorliegt und synthetisiert und hergestellt wird durch Umsetzung eines multifunktionellen Epoxidharzes (a) mit niedrigem Dk mit Acrylsäure (b), und Reagieren mit einem gesättigten oder ungesättigten Säureanhydrid (c) ausgewählt aus Bernsteinsäureanhydrid, Maleinsäureanhydrid, Hexahydrophthalsäureanhydrid, Methyltetrahydrophthalsäureanhydrid oder cis-4-Methyl-1,2,3,6-tetrahydrophthalsäureanhydrid, wobei die Reaktionsbedingung vorzugsweise innerhalb des folgenden Bereichs liegt, um die beste Wirkung zu erzielen: das multifunktionelle Epoxidharz mit niedrigem Dk überwiegt mengenmäßig für die Reaktion zwischen dem multifunktionellen Epoxidharz mit niedrigem Dk (a) und der Acrylsäure (b) und die Epoxidgruppe jedes Äquivalentgewichts soll vorzugsweise 0,5-1,2 Mol und am meisten bevorzugt 0,9-1,1 Mol sein; während der Reaktion ist das organische Lösungsmittel zwecks Verdünnung zuzugeben, wie beispielsweise aromatisches Lösungsmittel auf Erdölbasis, Propylencarbonat, Butoxyethanol, Butoxyethylacetat, Methylbenzol, Dimethylbenzol, Butylcarbitolacetat, Cyclohexanon, Propylenglykolmonomethylether, Dipropylenglykoldiethylether, Methylcarbitolacetat; und der Katalysator wird hinzugefügt, wie beispielsweise Triphenylphosphin, Triethylamin, Methyltriethylammoniumchlorid, wobei das Triphenylphosphin die beste Wahl sein soll; der Katalysator soll vorzugsweise in einer Menge von 0,1-10 Gew.-% der Gesamtmenge des Reaktionsgemisches vorliegen; der thermische Polymerisationsinhibitor soll zugegeben werden, wie p-Dihydroxybenzol und Hydrochinondimethylether, um die Polymerisation während der Reaktion zu verhindern; der Polymerisationsinhibitor soll vorzugsweise in einer Menge von 0,01-1 Gew.-% der zu reagierenden Mischung nach der Zufuhr vorliegen, und die Reaktionstemperatur soll vorzugsweise bei 80-120 °C liegen, und die Reaktion soll für 6-24 Stunden dauern; und in dem Schritt der Reaktion mit gesättigtem oder ungesättigtem Anhydrid (c) überwiegt das bei der Reaktion zwischen der Carboxyl- und der Epoxidgruppe erzeugte Hydroxyl in Bezug auf die Menge des verwendeten Polyanhydrids, 0,1-1,0 Mol Anhydrid soll auf das Hydroxyl mit äquivalentem Gewicht verwendet werden, und am meisten bevorzugt 0,3-0,7 Mol; die Reaktion soll vorzugsweise bei 80-120 °C durchgeführt werden und die Reaktion soll 4-16 Stunden andauern.

3. Die Zusammensetzung gemäß Anspruch 1, wobei die Dosierung des Komponente (B) photopolymerisierbaren Vinylmonomers bei einer Menge von 0-20 Gew.-% und am meisten bevorzugt bei einer Menge von 5-15 Gew.-% liegt, und die Komponente (B) ausgewählt ist aus Acrylat enthaltend Tripolycyanamid, Hydroxyalkylacrylat - wie eine Monoacrylsäureverbindung von 2-Hydroxyethylacrylat und 2-Hydroxybutylacrylat - Acrylat enthaltend zweiwertigen Alkohol - wie Glykol, Polyglykol, Propandiol - Alkylaminacrylsäureverbindung, Stickstoff-Dimethylaminoethyl, Acrylat einschließlich Polyhydrol - wie Glykol, Trimethylpropan, Pentaerythrit, Dipentaerythrit - und Acrylat enthaltend Ethylenoxid, multifunktionelles Acrylat von Propylenoxid - das selbst adduziert werden kann - und Acrylat von Allylglycidylether - Glycidyldiepoxyether, Trimethylolpropandiepoxypropylether und Melamincyanurattriepoxyisoamylpropionat - und am meisten bevorzugt Acrylat von Pentaerythrit oder Acrylat von Tripolycyanamid, multifunktionelles Acrylat von Dipentaerythrit.

4. Die Zusammensetzung gemäß Anspruch 1, wobei die Komponente (C) Epoxidharzverbindung in einer Menge von 5-30 Gew.-% und am meisten bevorzugt in einer Menge von 10-25 Gew.-% vorliegt, und die Epoxidharz-Komponente (C) einen ersten Teil (C1), ausgewählt aus Dicyclopentadien-Phenol-Novolac-Multifunktionsepoxidharz mit einem Epoxid-Äquivalent EEW von 272 g/eq und einem Erweichungspunkt bei 78-85 °C, oder Polyphenylether-modifiziertem Epoxidharz mit einem Epoxid-Äquivalent EEW von 340 g/eq und einem mittleren Molekulargewicht von Mn1300, oder Phenol-Benzaldehyd-Novolak-Multifunktionsepoxidharz mit einem Epoxid-Äquivalent EEW von 230 g/eq und einem mittleren Molekulargewicht von Mn1150, oder beliebigen Kombinationen der drei oben genannten Epoxidharze; einen zweiten Teil, der ein Tetramethylbiphenolepoxidharz (C2) ist, und einen dritten Teil, der eine mehrwertige Phenolverbindung ist, deren phenolische Hydroxylgruppe als das aktive Esterharz (C3) arylverestert und ausgewählt ist aus einer beliebigen veresterten Struktur des Phenolharzes, enthält, wobei das Säureäquivalent des oben erwähnten polymerisierbaren Oligomers in Bezug auf die Dosierung der verwendeten Epoxidharzverbindung überwiegt, und 1,0-5,0 Mol, vorzugsweise 1,0-2,5 Mol der Epoxidgruppe soll äquivalent zu der Carboxylgruppe verwendet werden; das gesamte Epoxidharz (C1)+(C2) soll in Bezug auf die Dosierung des Aktivesterharzes (C3) überwiegen, vorzugsweise 0-1,0 Mol Aktivesterharz sollen äquivalent zu der Epoxidgruppe verwendet werden.

5. Die Zusammensetzung gemäß Anspruch 1, wobei die Dosierung des Komponente (D) Photopolymerisationsinitiators der lötbeständigen Zusammensetzung mit niedriger Dielektrizitätskonstante und niedrigem Verlustfaktor in der Erfindung bei einer Menge von 2-10 Gew.-% und vorzugsweise bei einer Menge von 2-8 Gew.-% liegt, und der Photopolymerisationsinitiator ausgewählt ist aus einem beliebigen der bekannten Photoinitiatoren, wie Benzoinmethylether, Benzoin, Isopropylether, 2,2-Dimethyl-2-phenylacetophenon, 1,1-Dichloracetophenon, 1-Hydroxycyclohexylphenylketon, 2-Methyl-1-[4-(methylthio)phenyl]-2-morpholinylacet-1-on, N,N-Dimethylaminoacetophenon, 2,4-Dimethyl-9-oxdibenzothian, 2,4-Diethyl-9-oxdibenzothian, 2-Chlor-9-oxdibenzothian, 2,4-Diisopropyl-9-oxdibenzothian, Benzophenondimethylacetal, Diphenylketon, Methyldiphenylketon, 4,4'-Dichlorbenzophenon, 4,4'-Diethylaminophenylketon, Michler-Keton, 4-Phenylmethylacyldiphenylphosphoroxid, der getrennt oder nach dem Mischen verwendet werden kann und vorzugsweise eine Kombination aus 2-Methyl-1-[4-(methylthio)phenyl]-2-morpholinylacet-1-on und 2,4-Diisopropyl-9-oxdibenzothian ist.

6. Die Zusammensetzung gemäß Anspruch 1, wobei die Dosierung des Komponente (E) anorganischen Füllstoffs bei einer Menge von 10-50 Gew.-% und am meisten bevorzugt bei einer Menge von 15-35 Gew.-% liegt und die anorganischen Füllstoffe, wie Talkumpuder, Magnesiumcarbonat, Calciumcarbonat, Aluminiumoxid, Siliciumdioxidpulver, nach dem Mischen verwendet werden.

7. Die Zusammensetzung gemäß Anspruch 1, wobei die Dosierung des Komponente (F) Beschleunigers bei einer Menge von 0-2,0 Gew.-% und am meisten bevorzugt bei einer Menge von 0,1-1,0 Gew.-% liegt und der Härtungsbeschleuniger ausgewählt werden kann aus Imidazolen, quatären Ammoniumverbindungen und quatären Phosphaten und üblicherweise Dimethylimidazol, Diphenylimidazol, Bis(hydroxymethyl)diphenylimidazol.

8. Die Zusammensetzung gemäß Anspruch 1, wobei die Dosierung des Komponente (G) organischen Lösungsmittels vorzugsweise bei einer Menge von 10-40 Gew.-% und am meisten bevorzugt bei einer Menge von 10-30 Gew.-% liegt und das organische Lösungsmittel vorzugsweise ausgewählt ist aus Propylencarbonat, Butoxyethanol, Butoxyethylacetat, Methylbenzol, Dimethylbenzol, Butylcarbitolacetat, Cyclohexanon, Propylenglykolmonomethylether, Dipropylenglykoldiethylether, Methylcarbitolacetat, und das Propylencarbonat und das Butoxyethylacetat sind vorzuziehen.

## Revendications

1. Une composition avec faible Dk/Df résistante au brasage contient les composants suivants :
A. un oligomère prépolymère photopolymérisable tel que représenté par la formule 1 en une quantité de 20 à 70 % en poids, préparé par : réaction d'époxy multifonctionnel dicyclopentadiène-phénol novolaque (a1), d'une résine époxy modifiée au polyphényléther (a2), ou d'un époxy multifonctionnel phénol-benzaldéhyde novolaque (a3), ou de toute combinaison de trois (a1), (a2), (a3) avec de l'acide acrylique (b), puis réaction avec un acide anhydride saturé ou insaturé (c) ;
B. un monomère vinylique photopolymérisable en une quantité de 0 à 20 % en poids comme diluant ;
C. un composé époxy en une quantité de 5 à 30 % en poids contenant une résine époxy multifonctionnelle dicyclopentadiène-phénol novolaque ou une résine époxy modifiée au polyphényléther ou une résine époxy multifonctionnelle phénol-benzaldéhyde novolaque ou toute combinaison des trois types de résines précédents (C1) ; une résine époxy de tétraméthylbiphénol (C2) ; et éventuellement une résine d'ester actif (C3) ;
D. un initiateur de photopolymérisation en une quantité de 2 à 10 % en poids ;
E. une charge inorganique en une quantité de 10 à 50 % en poids ;
F. un catalyseur en une quantité de 0-2,0 % en poids ;
G. un solvant organique en une quantité de 10 à 40 % en poids ; 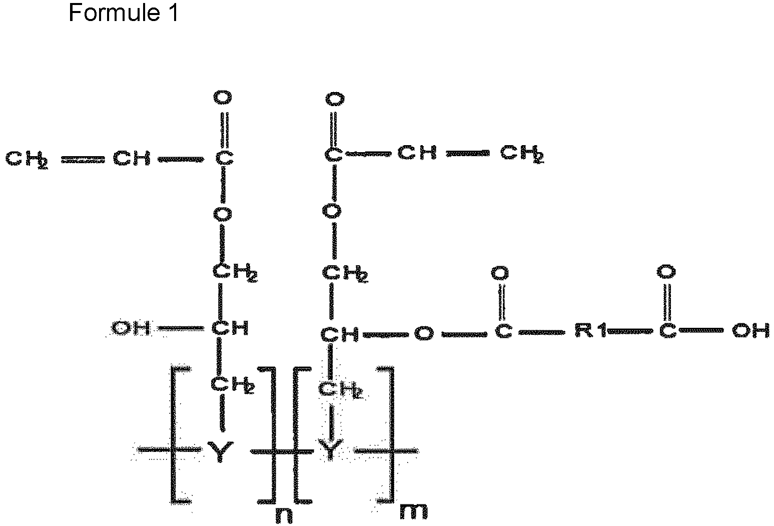 n, m > 0, entier
**R1:** 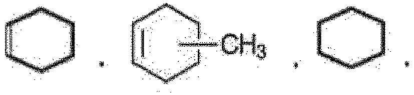 CH₂-CH₂ CH-CH
**Y:** 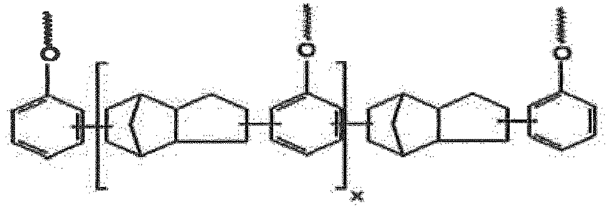 ou 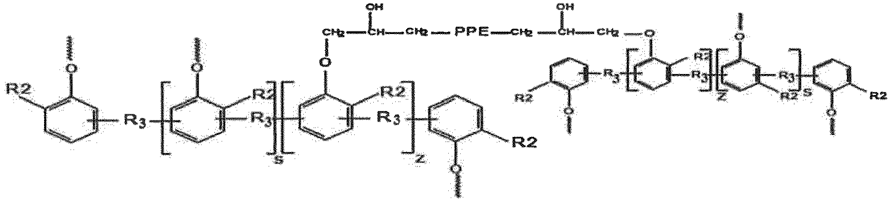 x, z, s > 0, entier
R3 : 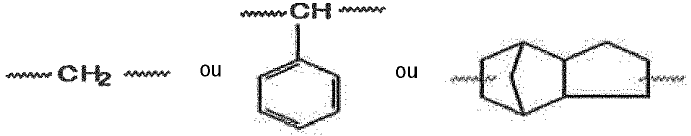 R2: H ou CH₃
ou 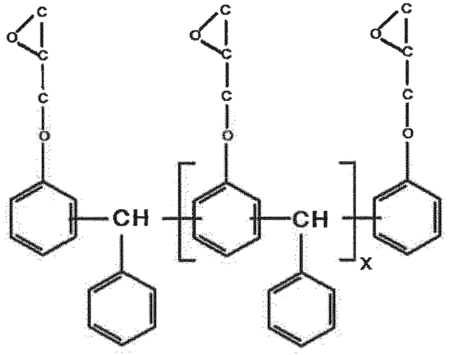 PPE: 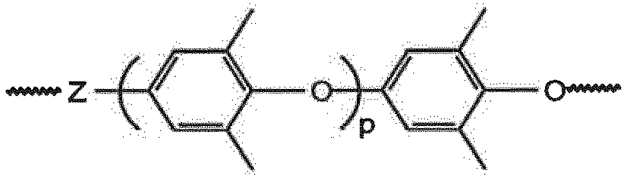 ou 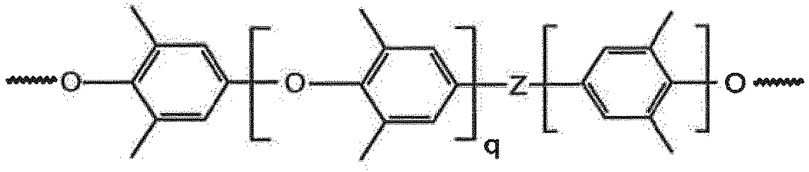 p, q > 1, entier
Z: 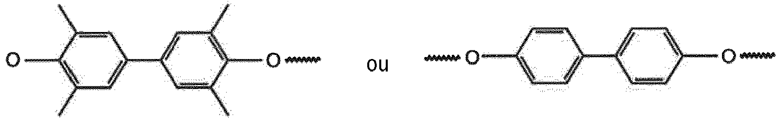 ou

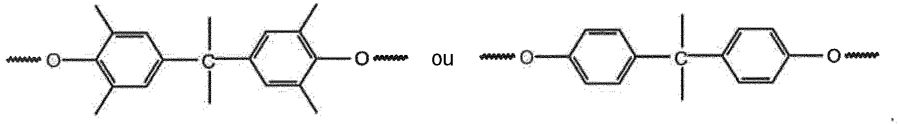

2. La composition avec faible Dk/Df résistante au brasage selon la revendication 1, dans laquelle l'oligomère prépolymère photopolymérisable de composant A est de préférence en une quantité de 20 à 70 % en poids et de préférence en une quantité de 30 à 60 % en poids et synthétisé et préparé en faisant réagir une résine époxy multifonctionnelle avec faible Dk (a) avec de l'acide acrylique (b), et en faisant réagir avec un anhydride d'acide saturé ou insaturé (c) choisi parmi l'anhydride succinique, l'anhydride maléique, l'anhydride hexahydrophtalique, l'anhydride méthyl tétrahydrophtalique ou l'anhydride cis-4-méthyl-1,2,3,6-tétrahydrophtalique, où la condition de réaction se situe de préférence dans la plage suivante afin d'obtenir le meilleur effet : la résine époxy multifonctionnelle avec faible Dk prévaut en termes de quantité pour la réaction entre la résine époxy multifonctionnelle avec faible Dk (a) et l'acide acrylique (b), et le groupe époxy de chaque poids équivalent doit être 0,5-1,2 mole de préférence, et 0,9-1,1 mole de préférence ; pendant la réaction, le solvant organique doit être appliqué à la dilution, tel que le solvant aromatique à base de pétrole, le carbonate de propylène, le butoxyéthanol, l'acétate de butoxyéthyle, le méthylbenzène, le diméthylbenzène, l'acétate de butylcarbitol, la cyclohexanone, l'éther monométhylique de propylèneglycol, l'éther diéthylique de dipropylèneglycol, l'acétate de méthylcarbitol ; et le catalyseur est ajouté, tel que la triphénylphosphine, la triéthylamine, le chlorure de méthyltriéthylammonium, la triphénylphosphine étant le meilleur choix ; le catalyseur doit être en quantité de 0,1 à 10 % en poids de la quantité totale du mélange pour la réaction, de préférence ; l'inhibiteur de polymérisation thermique doit être ajouté, tel que le p-dihydroxybenzène et l'hydroquinone diméthyl éther, afin d'empêcher la polymérisation pendant la réaction ; l'inhibiteur de polymérisation doit être en une quantité de 0,01-1% en poids du mélange pour la réaction après alimentation de préférence, et la température de réaction doit être de 80-120°C de préférence, et la réaction doit durer 6-24h ; et dans l'étape de réaction avec l'anhydride saturé ou insaturé (c), l'hydroxyle généré pendant la réaction entre le carboxyle et le groupe époxy prévaut en termes de quantité d'anhydride utilisée, la 0,1-1,0 mole d'anhydride doit être appliquée à l'hydroxyle de poids équivalent, et 0,3-0,7 mole de préférence ; la réaction doit être mise en œuvre à 80-120°C de préférence, et la réaction doit durer 4-16h.

3. La composition selon la revendication 1, dans laquelle le dosage du monomère vinylique photopolymérisable de composant (B) est en une quantité de 0 à 20% en poids, et de préférence en une quantité de 5 à 15% en poids, et le composant (B) est choisi parmi l'acrylate, comprenant le tripolycyanamide, l'acrylate d'hydroxyalkyle - tel que le composé d'acide monoacrylique de l'acrylate de 2-hydroxyéthyle et l'acrylate de 2-hydroxybutyle - l'acrylate comprenant l'alcool dihydrique - tel que le glycol, le polyglycol, le propanediol - le composé d'acide acrylique d'amine d'alkyle, l'azote-diméthylaminoéthyle, l'acrylate comprenant le polyhydrol - tel que le glycol, le triméthylpropane, le pentaérythritol, le dipentaérythritol - et l'acrylate comprenant l'oxyde d'éthylène, l'acrylate multifonctionnel d'oxyde de propylène - qui peut être lui-même adduit - et l'acrylate d'éther glycidylique allylique - l'éther diépoxydique glycidylique, l'éther diépoxypropylique de triméthylolpropane, et le propionate de mélaminecyanurate triépoxy isoamyle - et de préférence l'acrylate de pentaérythritol ou l'acrylate de tripolycyanamide, l'acrylate multifonctionnel de dipentaérythritol.

4. La composition selon la revendication 1, dans laquelle le composé de résine époxy de composant (C) est présent en une quantité de 5 à 30 % en poids, et de préférence en une quantité de 10 à 25 % en poids, et le composant de résine époxy (C) contient une première partie (C1) choisie parmi la résine époxy multifonctionnelle dicyclopentadiène-phénol novolaque ayant un équivalent d'époxy EEW de 272g/eq et un point de ramollissement à 78-85°C ou une résine époxy modifiée au polyphényléther ayant un équivalent d'époxy EEW de 340 g/eq et un poids moléculaire moyen de Mn1300 ou une résine époxy multifonctionnelle phénol-benzaldéhyde novolaque ayant un équivalent d'époxy EEW de 230 g/eq et un poids moléculaire moyen de Mn1150 ou des combinaisons arbitraires des trois résines époxy mentionnées ci-dessus ; une deuxième partie qui est une résine époxy tétraméthyl biphénol (C2) et une troisième partie qui est un composé phénolique polyhydrique dont le groupe hydroxyle phénolique est aryl-estérifié en tant que résine d'ester actif (C3) et est choisi parmi l'une quelconque de structures estérifiées de la résine phénolique, où l'équivalent acide de l'oligomère polymérisable susmentionné doit prévaloir en termes de dosage du composé de résine époxy utilisé, et 1,0-5,0 mole de groupe époxy doit être appliquée au groupe carboxylique de manière équivalente, de préférence 1,0-2,5 mole ; la résine époxy totale (C1)+(C2) doit prévaloir en termes de dosage de la résine d'ester actif (C3), de préférence 0-1,0 mole de résine d'ester actif doit être appliquée au groupe époxy de manière équivalente.

5. La composition selon la revendication 1, dans laquelle le dosage de l'initiateur de photopolymérisation de composant (D) de la composition résistante au brasage avec une faible constante diélectrique et un faible facteur de dissipation dans l'invention est en une quantité de 2-10 % en poids et de préférence en une quantité de 2-8 % en poids, et l'initiateur de photopolymérisation est choisi parmi les photo-initiateurs connus, tels que l'éther méthylique de benjoin, le benjoin, l'éther isopropylique, la 2,2-diméthyl-2-phénylacétophénone, la 1,1-dichloroacétophénone, la 1-hydroxy cyclohexyl phényl cétone, 2-méthyl-1-[4-(méthylthio) phényl]-2-morpholinylacet-1-one, N,N-diméthyl amino acétophénone, 2,4-diméthyl 9-oxdibenzothiane, 2,4-diéthyl 9-oxdibenzothiane, 2-chloro-9-oxdibenzothiane, 2,4-diisopropyl 9-oxdibenzothiane, benzophénone diméthyl acétal, diphénylcétone, méthyl diphénylcétone, 4, 4'-dichlorobenzophénone, 4,4'-diéthylamino phénylcétone, cétone de Michler, oxyde de phosphore de 4-phénylméthylacyldiphényle, qui peut être utilisé séparément ou après mélange, et qui est de préférence une combinaison de 2-méthyl-1-[4-(méthylthio) phényl]-2-morpholinylacet-1-one et de 2,4-diisopropyl 9-oxdibenzothiane.

6. La composition selon la revendication 1, dans laquelle le dosage de la charge inorganique de composant (E) est en une quantité de 10-50% en poids et le plus préférablement en une quantité de 15-35% en poids, et les charges inorganiques, telles que la poudre de talc, le carbonate de magnésium, le carbonate de calcium, l'alumine, la poudre de dioxyde de silicium sont utilisées après mélange.

7. La composition selon la revendication 1, dans laquelle le dosage de l'accélérateur de composant (F) est en une quantité de 0-2,0 % en poids et le plus préférablement en une quantité de 0,1-1,0 % en poids, et l'accélérateur de durcissement peut être choisi parmi les imidazoles, les composés d'ammonium quaternaire et les phosphates quaternaires, et communément le diméthylimidazole, le diphénylimidazole, le bis(hydroxyméthyl) diphénylimidazole.

8. La composition selon la revendication 1, dans laquelle le dosage du solvant organique de composant (G) est de préférence en une quantité de 10 à 40 % en poids et de préférence en une quantité de 10 à 30 % en poids, et le solvant organique est de préférence choisi parmi le carbonate de propylène, le butoxyéthanol, l'acétate de butoxyéthyle, le méthylbenzène, le diméthylbenzène, l'acétate de butylcarbitol, la cyclohexanone, l'éther monométhylique de propylèneglycol, l'éther diéthylique de dipropylèneglycol, l'acétate de méthylcarbitol, et le carbonate de propylène et l'acétate de butoxyéthyle sont plus préférables.
